(19) Europäisches Patentamt

European Patent Office

Office européen des brevets

(11) Veröffentlichungsnummer : **0 439 649 B1**

(12) **EUROPÄISCHE PATENTSCHRIFT**

(45) Veröffentlichungstag der Patentschrift :
05.07.95 Patentblatt 95/27

(21) Anmeldenummer : 90101825.9

(22) Anmeldetag : 30.01.90

(51) Int. Cl.⁶ : **H03M 13/00**

(54) **Einrichtung zur Fehlermustergenerierung bei Soft-Decision-Decodierung von Blockcodes.**

(43) Veröffentlichungstag der Anmeldung :
07.08.91 Patentblatt 91/32

(45) Bekanntmachung des Hinweises auf die
Patenterteilung :
05.07.95 Patentblatt 95/27

(84) Benannte Vertragsstaaten :
**CH DE GB IT LI NL**

(56) Entgegenhaltungen :
EP-A- 0 147 623
GB-A- 2 185 367
US-A- 4 573 155
US-A- 4 821 268
US-A- 4 890 286
IEEE TRANSACTIONS ON INFORMATION
THEORY. vol. 35, no. 5, September 1989, NE-
WYORK US Seiten 963 - 975; JAKOV SNYDERS
ET AL: "MAXIMUM LIKELIHOOD SOFT DECO-
DING OF BINARY BLOCK CODES AND DECO-
DERS FOR THE GOLAY CODES"
INTERNATIONAL JOURNAL OF ELECTRO-
NICS. vol. 66, no. 3, März 1989, LONDON
GBSeiten 321 - 332; O.O.OLANIYAN:
"IMPLEMENTABLE SOFT DECODING SCHE-
MES"
PATENT ABSTRACTS OF JAPAN vol. 9, no.
270 (E-353)(1993) 26 Oktober 1985, & JP-A-60
116229 (MITSUBISHI DENKI KABUSHIKI KAIS-
HA) 22 Juni 1985,
IEEE/IEICE GLOBAL TELECOMMUNICATION
CONFERENCE vol. 3, 18 November 1987,
NEW-YORK Seiten 2090 - 2094; NOBUKAZU
DOI ET AL.: "SOFT DECISION DECODING
FOR REED SOLOMON CODES"
IEEE INTERNATIONAL SYMPOSIUM ON IN-
FORMATION THEORY 09 Oktober 1986,
NEW-YORK Seite 48 WANG XIN MEI: "FAST
SOFT DECISION DECODING OF CYCLIC CO-
DES"

(56) Entgegenhaltungen :
IEEE TRANSACTIONS ON INFORMATION
THEORY. vol. 18, no. 1, Januar 1972, NEW
YORK US Seiten 170 - 182; DAVID CHASE: "A
CLASS OF ALGORITHMS FOR DECODING
BLOCKCODES WITH CHANNEL MEASURE-
MENT INFORMATION"

(73) Patentinhaber : SIEMENS
AKTIENGESELLSCHAFT
Wittelsbacherplatz 2
D-80333 München (DE)

(72) Erfinder : **Friederichs, Karl-Josef, Dr.-Ing.**
**Blütenstrasse 65a**
**D-8039 Puchheim (DE)**

## Beschreibung

Die Erfindung bezieht sich auf eine Einrichtung zur Fehlermustergenerierung bei Soft-Decision-Decodierung von Blockcodes nach dem Chase-Algorithmus oder einer Variante von diesem Algorithmus, in der aus dem Syndrom als einer aus jedem empfangenen Datenblock von den gesendeten Nutzdaten unabhängigen Schätzgröße für mögliche Übertragungsfehler und den Positionen von mittels Soft-Decision ausgesuchten Symbolen mit geringer Zuverlässigkeit mehrere mögliche Fehlermuster erzeugt werden.

Bei der Decodierung von fehlerkorrigierenden Codes kann die Korrekturfähigkeit des Decoders durch den Einsatz von Soft-Decision in der Regel deutlich gegenüber der einer Hard-Decision-Decodierung verbessert werden. Ein möglicher Algorithmus zur Decodierung von Blockcodes ist der Chase-Algorithmus, der beispielsweise in "Error-Correction Coding for Digital Communications" von G. C. Clark, Jr und J. B. Cain, Plenum Press, New York 1982 beschrieben ist. Daneben sind zahlreiche Varianten und Abwandlungen des Chase-Algorithmus bekannt.

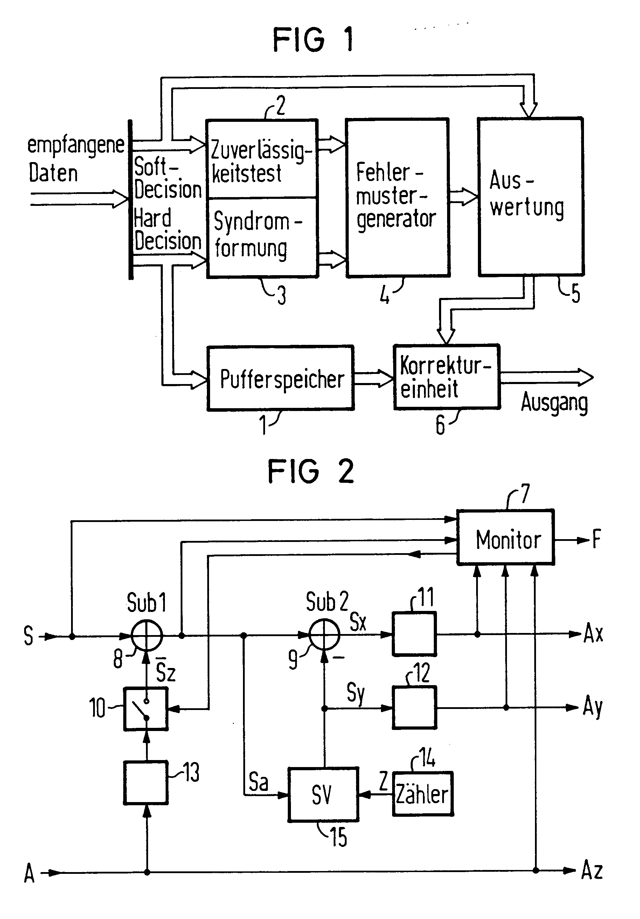

Im folgenden soll das Grundprinzip, nach dem die meisten Soft-Decision-Decodieralgorithmen für Blockcodes funktionieren, anhand der in Figur 1 dargestellten Blockstruktur näher erläutert werden. Die empfangenen digitalen Datensignale werden zunächst in ihre Hard- und Soft-Decision-Anteile aufgespalten. Die Hard-Decision-Daten werden zum einen in einen Pufferspeicher 1 geschoben, zum anderen wird aus ihnen für jeden empfangenen Datenblock eine von den gesendeten Nutzdaten unabhängige Schätzgröße für mögliche Übertragungsfehler, das sogenannte Syndrom erzeugt (Syndromformung 3). Parallel hierzu werden in der Funktionseinheit Zuverlässigkeitstest 2 ein oder mehrere Symbole ausgesucht, deren Soft-Decision eine geringe Zuverlässigkeit signalisiert. Aus dem Syndrom und den Positionen der Symbole mit geringer Zuverlässigkeit werden in einem Fehlermustergenerator 4 mehrere mögliche Fehlermuster erzeugt. In der Funktionseinheit Auswertung 5 wird dann aus diesen Fehlermustern unter Ausnutzung von Soft-Decision-Information dasjenige ausgewählt, welches am wahrscheinlichsten ist. Schließlich werden die in dem Pufferspeicher 1 zwischengespeicherten Daten in der Korrektureinheit 6 gemäß dem ausgewählten Fehlermuster korrigiert.

Der Fehlermustergenerator besteht in der Regel aus einem oder mehreren Speicherbausteinen, in denen die möglichen Fehlermuster in Tabellenform abgelegt sind. Dieser Speicher wird dann von dem Syndrom und ggf. von den Positionen der Symbole mit geringer Zuverlässigkeit adressiert. Nachteilig hierbei ist, daß je nach Blocklänge und Leistungsfähigkeit des verwendeten Codes ein sehr großer Speicherplatz erforderlich ist, der sich nicht mehr für eine Integration in einem Semi-Custom IC, z. B. einem Gate Array eignet. Beispielsweise ist für die Fehlermustertabelle eines erweiterten (16,11) Hamming Codes ein Speicher der Organisation $2^{11}$x12 Bit erforderlich und bei einem erweiterten (32,26) Hamming Code würde ein Speicher der Organisation $2^{14}$x15 Bit benötigt. Bei der Integration des entsprechenden Decoders in einem Gate Array müßte die Fehlermustertabelle in einem externen Speicher abgelegt werden. Darüber hinaus sind derzeit noch keine Speicherbausteine in der oben genannten Größenordnung verfügbar, die kurze Zugriffszeiten mit Taktfrequenzen von einigen zehn Megahertz erlauben.

Der Erfindung liegt die Aufgabe zugrunde, für eine Einrichtung zur Fehlermustergenerierung der eingangs beschriebenen Art eine einfache Lösung anzugeben.

Diese Aufgabe wird gemäß der Erfindung in der im kennzeichnenden Teil des Anspruchs 1 angegebenen Weise gelöst.

Vorteilhafte Ausgestaltungen und Weiterbildungen des Erfindungsgegenstandes sind in den Unteransprüchen angegeben.

Nachstehend wird die Erfindung anhand von in der Zeichnung dargestellten Ausführungsbeispielen näher erläutert.

Es zeigen

Fig. 2 das Blockschaltbild eines Fehlermustergenerators,

Fig. 3 das Prinzipschaltbild der Funktionsgruppe Syndromvorgabe und

Fig. 4 das Schaltbild einer möglichen Realisierung der Funktionsgruppe Syndromvorgabe mit logischen Gatterfunktionen bei einer Syndrombreite von 5 Bit.

Figur 2 zeigt einen Fehlermustergenerator, der die entsprechenden Positionskombinationen zur Korrektur von ein-, zwei- oder dreifachen Fehlern innerhalb eines Datenblocks der Länge N erzeugen soll. Dabei wird der Generator am Eingang von dem Syndrom S und von der Position A des unzuverlässigsten Symbols eines empfangenen Datenblocks gespeist. Das Syndrom S wird u. a. einer Funktionsgruppe Monitor 7 zugeführt. Das Syndrom S gelangt zugleich an einen ersten Subtrahierer 8, dessen zweiter Eingang über, einen vom Monitor 7 angesteuerten Schalter 10 mit einer ersten Tabelle 13 verbunden ist, die von der Position A des unzuverlässigsten Symbols eines empfangenen Datenblocks gespeist wird. Der Ausgang des ersten Subtrahierers 8 ist einerseits mit dem Monitor 7 und zum anderen mit einem zweiten Subtrahierer 9 sowie mit einer Funktionsgruppe Syndromvorgabe 15 verbunden, die zugleich an einen Zähler 14 angeschlossen ist und ausgangsseitig mit dem zweiten Eingang des zweiten Subtrahierers 9 verbunden ist. Der Ausgang des zweiten Subtrahierers 9 ist an eine dritte Tabelle 11 geführt, der Ausgang der Syndromvorgabe 15 ist zugleich mit einer zweiten Tabelle 12 verbunden. Der Ausgang der dritten und zweiten Tabelle 11 bzw. 12 bildet den Ausgang Ax bzw. Ay und ist zugleich auch an den Monitor 7 angeschlossen. Eine durchgehende Verbindung führt von der Position A des unzuverlässigsten Symbols eines empfangenen Datenblocks zum Ausgang Az sowie mit einem Anschluß an den Monitor 7.

Im folgenden wird die Funktionsweise des Fehlermustergenerators näher erläutert: Nachdem das Syndrom S dem Monitor 7 zugeführt wird, überprüft dieser zunächst, ob das Syndrom Null ist. Im Fall $S = 0$ wird angenommen, daß kein Übertragungsfehler aufgetreten ist. Dieses wird über den Ausgang F an die nachfolgenden, in der Figur nicht dargestellten Funktionseinheiten des Decoders mitgeteilt. Die Ausgänge Ax bis Az des Fehlermustergenerators können dann ignoriert werden. Im Fall $S \neq O$ kann der Monitor 7 anhand des niederwertigsten Syndrombits entscheiden, ob die Anzahl der zu betrachtenden Fehler geradzahlig oder ungeradzahlig ist. Hierzu ist allerdings vorauszusetzen, daß das niederwertigste Syndrombit ein "Overall-Parity-Check-Bit" ist. Dies sei im folgenden gegeben.

Es wird zunächst der Fall betrachtet, daß das niederwertigste Syndrombit Null ist. In diesem Fall wird angenommen, daß zwei Fehler zu korrigieren sind. Das ankommende Syndrom S setzt sich dann gemäß

$$S = Sx + Sy \quad (1)$$

additiv aus zwei Teilsyndromen Sx und Sy zusammen. Aufgabe des Generators ist es nun, die zu Sx und Sy gehörigen Positionen zu ermitteln. Hierzu wird der Schalter 10 durch die Funktionsgruppe Monitor 7 geöffnet, so daß das Syndrom S unverändert über den ersten Subtrahierer 8 an den Eingang des zweiten Subtrahierers 9 gelangt. Dann ist das aufbereitete Signal $Sa = S$. Es ist bekannt, daß für G1. (1) genau N/2 mögliche Lösungspaare bezüglich Sx und Sy existieren. Mit Hilfe der Funktionsgruppe Syndromvorgabe 15 werden nun - gesteuert durch den Zähler 14 und durch das Syndrom S - nacheinander N/2 mögliche Syndrome Sy vorgegeben und dem zweiten Subtrahierer 9 sowie der zweiten Tabelle 12 zugeführt. Am Ausgang des zweiten Subtrahierers 12 erhält man dann zu jedem vorgegebenen Syndrom Sy das zugehörige Syndrom

$$Sx = S - Sy \quad (2)$$

Die Syndromvorgabe durch die Funktionsgruppe 15 darf hierbei allerdings nicht willkürlich erfolgen, sondern es müssen solche Vorgaben für Sy erzeugt werden, daß sich insgesamt N/2 unterschiedliche aufeinanderfolgende Syndrompaare (Sx, Sy) ergeben. Für beliebiges, aber konstantes $S \neq O$ dürfen also innerhalb von N/2 aufeinanderfolgenden Taktschritten keinerlei Wiederholungen auftreten. Dieses ist möglich, wenn man zuläßt, daß die Vorgaben für Sy gemäß

$$Sy = f(Z, Sa) \quad (3)$$

Funktionen des Zählerstandes Z sowie des Syndroms Sa sind. Die genaue Funktionsweise der Funktionsgruppe Syndromvorgabe 15 wird an späterer Stelle noch beschrieben. Die Syndrompaare Sx und Sy werden mittels der beiden Tabellen 11 und 12 in die zugehörigen Positionspaare Ax und Ay umcodiert und zum Ausgang geführt. Insgesamt erhält man also an den Ausgängen Ax und Ay nacheinander die gewünschten N/2 Positionskombinationen, die bei einem zweifachen Fehler innerhalb eines Blocks möglich sind. Die Funktionsgruppe Monitor 7 meldet über den Ausgang F an die nachfolgenden Funktionseinheiten des Decoders, daß ein zweifacher Fehler zu berücksichtigen ist und daß der Ausgang Az zu ignorieren ist.

Es wird nun der Fall betrachtet, daß das niederwertigste Syndrombit Eins ist. In diesem Fall wird angenommen, daß entweder ein einfacher oder ein dreifacher Fehler zu korrigieren ist. Bei einem dreifachen Fehler setzt sich das Syndrom S gemäß

$$S = Sx + Sy + Sz \quad (4)$$

aus drei Teilsyndromen zusammen, wobei

$$Sx \neq Sy \neq Sz \neq Sx \quad (5)$$

ist. Bei einem einfachen Fehler repräsentiert das Syndrom unmittelbar die Position des Fehlers innerhalb des Blocks. Dieser Fall wird von Gl. (4) erfaßt, wenn mindestens eine der drei Gleichungen

$$Sx = - Sy \quad (6)$$
$$Sx = - Sz \quad (7)$$
$$Sy = - Sz \quad (8)$$

gilt. Insgesamt muß der Fehlermustergenerator zur Bestimmung der gewünschten Fehlermuster die Lösungen von Gl. (4) bezüglich Sx, Sy und Sz finden. Ferner müssen bei diesen Lösungen die Fälle nach Gln. (6,7,8) überwacht werden, um zwischen einem einfachen und einem dreifachen Fehler zu unterscheiden. Die Suche nach Lösungen für Gl. (4) wird vereinfacht, indem man annimmt, daß bei einem dreifachen Fehler eine mögliche Fehlerposition mit der Position A des Symbols mit der geringsten Zuverlässigkeit übereinstimmt. Diese Position A wird dem Fehlermustergenerator über einen Eingang vorgegeben und gleichzeitig als mögliche Position Az für eine Fehlerposition zum Ausgang geführt. Ferner wird die Position A über die erste Tabelle 13 in das entsprechende Syndrom Sz umcodiert. Der Schalter 10 wird durch die Funktionsgruppe Monitor 7 geschlossen, so daß das Syndrom Sz über den ersten Subtrahierer 8 von dem Syndrom S subtrahiert wird. Am Ausgang des ersten Subtrahierers 8 erhält man dann das aufbereitete Syndrom

$$Sa = S - Sz = Sx + Sy \quad (9)$$

Sofern $Sa \neq O$ ist, existieren für dieses aufbereitete Syndrom wiederum N/2 Lösungsmöglichkeiten bezüglich Sx und Sy. Diese Lösungen werden wie im Fall des zweifachen Fehlers wieder mit Hilfe der Funktionsgruppe Syndromvorgabe 15 ermittelt und in die zugehörigen Positionen Ax und Ay umcodiert. Zur Unterscheidung zwischen einem einfachen und einem dreifachen Fehler werden das aufbereitete Syndrom Sa sowie die drei Positionen Ax, Ay und Az von der Funktionsgruppe Monitor 7 überwacht. Im Fall $Sa = O$ gilt auch $Sx = -Sy$. Die Position des zugehörigen einfachen Fehlers wird dann durch die Position Az angegeben, während die Positionen Ax und Ay zu ignorieren sind. Wenn $Sa \neq O$ ist, überprüft die Funktionsgruppe Monitor 7, ob Ax = Az und damit $Sx = -Sz$ ist, oder Ay = Az und damit $Sy = -Sz$ ist. In diesen beiden Fällen wird die Position des zugehörigen einfachen Fehlers durch die Position Ay bzw. Ax repräsentiert. Insgesamt gibt der Fehlermustergenerator also an den Ausgängen Ax bis Az die gewünschten Positionskombinationen der Fehlerpositionen an und zeigt über den Ausgang F an, wieviele Fehler momentan zu berücksichtigen sind sowie welche der Adressen Ax bis Az momentan gültig sind.

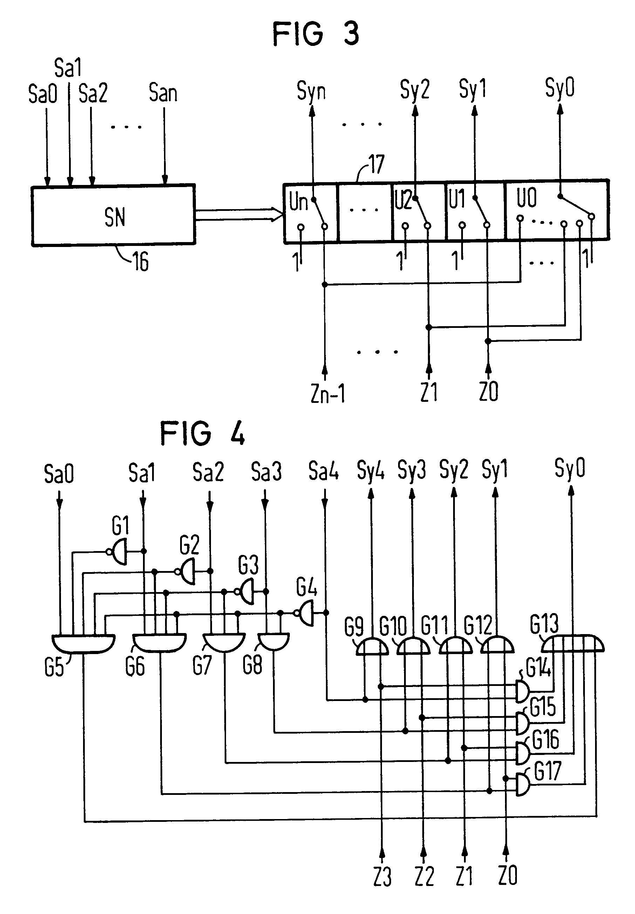

Im folgenden werden anhand des Schaltbildes nach Figur 3 Aufbau und Funktionsweise der Funktionsgruppe Syndromvorgabe 15 beschrieben. Aufgabe dieser Funktionsgruppe ist es, gemäß Gl. (3) aus dem aufbereiteten Syndrom Sa und den Zählerständen $Z = O..., N/2 -1$ je ein Syndrom Sy zu generieren. Die Funktionsgruppe Syndromvorgabe 15 besteht aus einem Schaltnetz 16 und einer Anordnung 17 von n+1 Umschaltern Uo bis Un. Die an den Eingängen des Schaltnetzes 16 anliegenden Syndrome Sa und die an den Mittelanzapfungen der Umschalter Uo bis Un abnehmbaren Syndrome Sy haben jeweils eine Wortbreite von n+1 Bit, während der Zählerstand Z eine Wortbreite von n Bit hat. Den Umschaltern Ul bis Un werden in der einen Schalterstellung die Zählerbits Zo bis Zn-1 und in der anderen Schalterstellung der logische Wert 1 zugeführt. Der Umschalter Uo weist eine der Anzahl der Zählerbits Zo bis Zn-1 entsprechende Zahl von Schalterstellungen sowie eine für den logischen Wert 1 auf.

In dem Schaltnetz 16 wird zunächst von den ankommenden Bits Sao bis San ein beliebiges Bit Sai ausgewählt, welches den logischen Wert 1 hat. Anhand dieser Auswahl werden dann die Umschalter folgendermaßen gesteuert: wenn Sai = Sao (d. h. i = 0) ist, wird die in Figur 3 dargestellte Schalterstellung beibehalten. Die Zählerbits Zo bis Zn-1 werden dann auf die Syndrombits Syl bis Syn durchgeschaltet und das Syndrombit Syo wird auf den logischen Wert 1 gelegt. In den übrigen Fällen (i = 1,.., n) wird das jeweilige Syndrombit Syi über den betreffenden Umschalter Ui auf den logischen Wert 1 gelegt und das zugehörige Zählerbit Zi-1 über den Umschalter Uo auf das Syndrombit Syo gelegt. Alle übrigen Zählerbits Zj-1, $j \neq i$ werden über die entsprechenden Umschalter auf die zugehörigen Syndrombits Syj geschaltet. Auf diese Weise wird sichergestellt, daß aus $2^n = N/2$ möglichen Zählerständen auch N/2 unterschiedliche Syndrompaare (Sx, Sy) erzeugt werden, wenn mindestens eines der Bits Sao bis San von Null verschieden ist. Hierbei kommt es nicht darauf an, welches der Bits Saj, $j = O,.., n$ mit Saj = 1 von dem Schaltnetz 16 ausgewählt wird. Diese Auswahl hat lediglich einen Einfluß auf die Reihenfolge, mit der die Syndrompaare (Sx, Sy) bei kontinuierlich fortschreitendem Zählerstand erzeugt werden, nicht aber auf die Syndrompaare (Sx, Sy) selbst.

In Figur 4 ist eine mögliche Realisierung der Funktionsgruppe Syndromvorgabe 15 mit logischen Gatterfunktionen bei einer Syndrombreite von 5 Bit dargestellt. In diesem Beispiel ist das Schaltnetz 16 mit den Invertern Gl bis G4 und UND-Gattern G5 bis G8 realisiert. Die Umschalter U1 bis U4 sind mit den ODER-Gattern G9 bis G12 realisiert, während der Umschalter Uo aus dem ODER-Gatter G13 sowie den UND-Gattern G14 bis G17 besteht.

## Patentansprüche

1.    Einrichtung zur Fehlermustergenerierung bei Soft-Decision-Decodierung von Blockcodes nach dem Chase-Algorithmus oder einer Variante von diesem Algorithmus, in der aus dem Syndrom als einer aus jedem empfangenen Datenblock von den gesendeten Nutzdaten unabhängigen Schätzgröße für mögliche Übertragungsfehler und den Positionen von mittels Soft-Decision ausgesuchten Symbolen mit geringer Zuverlässigkeit mehrere mögliche Fehlermuster erzeugt werden,
**dadurch gekennzeichnet,**
daß das dem Eingang der Einrichtung zugeführte Syndrom (S), bestehend aus einer der Anzahl möglicher Fehler entsprechenden Anzahl von Teilsyndromen, zum einen auf eine einen Meldeausgang aufweisende Funktionsgruppe Monitor (7) gegeben wird zur Feststellung, ob das Syndrom null ist und ob bei negativem Ergebnis die Anzahl der zu betrachtenden Fehler geradzahlig oder ungeradzahlig ist, und zum anderen auf den einen Eingang eines ersten Subtrahierers (8) gegeben wird, dessen zweiter Eingang mit dem einen Schaltkontakt eines vom Monitor (7) angesteuerten Schalters (10) verbunden ist, dessen zweiter Schaltkontakt mit einem weiteren Eingang der Einrichtung verbunden ist, über den der Einrichtung bei Annahme eines mehrfachen Fehlers eine mögliche Fehlerposition mit der Position A des Symbols mit der geringsten Zuverlässigkeit vorgegeben und gleichzeitig als mögliche Position für eine Fehlerposition zum Ausgang geführt wird, wobei die Position A über eine erste Tabelle (13) in das entsprechende Teilsyndrom (Sz) umcodiert wird, das bei geschlossenem Schalter (10) über den ersten Subtrahierer (8) vom Syndrom (S) subtrahiert wird, daß der Ausgang des ersten Subtrahierers (8) einerseits mit dem einen Eingang eines zweiten Subtrahierers (9) und andererseits mit einer durch einen Zähler (14) gesteuerten Funktionsgruppe Syndromvorgabe (15), die nacheinander N/2 Syndrome generiert, verbunden ist, deren Ausgang mit dem zweiten Eingang des zweiten Subtrahierers (9) sowie mit einer zweiten Tabelle (12) verbunden ist, mittels der das Teilsyndrom (Sy) in die zugehörige Position (Ay) umcodiert und zum Ausgang geführt wird, während der andere Ausgang des zweiten Subtrahierers (9) an eine dritte Tabelle (11) geführt ist, mittels der das Teilsyndrom (Sx) in die zugehörige Position (Ax) umcodiert und zum Ausgang geführt wird und daß das aufbereitete Syndrom (Sa) am Ausgang des ersten Subtrahierers (8) sowie die drei Positionen (Ax, Ay und Az) von der Funktionsgruppe Monitor (7) überwacht werden.

2. Einrichtung nach Anspruch 1,
**dadurch gekennzeichnet**,
daß an den Ausgängen (Ax, Ay und Az) die gewünschten N/2 Positionskombinationen anstehen, die bei einem entsprechenden Fehler innerhalb eines Blocks möglich sind und die Funktionsgruppe Monitor (7) über ihren Ausgang an die nachfolgenden Funktionseinheiten des Decoders meldet, daß ein bestimmter Fehler zu berücksichtigen ist und welcher Ausgang im jeweiligen Fall zu ignorieren ist.

3. Einrichtung nach Anspruch 1 oder 2, **dadurch gekennzeichnet**, daß die Funktionsgruppe Syndromvorgabe (15) aus einem Schaltnetz (16), an dem die aufbereiteten Syndrombits anliegen und einer vom Schaltnetz (16) gesteuerten Anordnung (17) von n+1 Umschaltern (Uo-Un) besteht, über die bei entsprechender Auswahl der aufbereiteten Syndrombits (Sao bis San) die Zählerbits (Zo -Zn-1) auf die betreffenden Syndrombits (Syl bis Syn) durchgeschaltet werden.

4. Einrichtung nach Anspruch 3, **dadurch gekennzeichnet**, daß die aufbereiteten Syndrome (Sa) und die Syndrome (Sy) jeweils eine Wortbreite n+l bit haben, der Zählerstand Z eine Wortbreite von n bit.

5. Einrichtung nach Anspruch 3 oder 4, **dadurch gekennzeichnet**, daß die Funktionsgruppe Syndromvorgabe (15) mit logischen Gatterfunktionen realisiert ist.

6. Verfahren zur Fehlermustergenerierung mit einer Einrichtung nach einem der Ansprüche 1 bis 5, **dadurch gekennzeichnet**, daß für den Null-Fall des niederwertigsten Syndrombits und der daraus folgenden Annahme von zwei zu korrigierenden Fehlern die zu den zwei Teilsyndromen (Sx, Sy) des ankommenden Syndroms gehörigen Positionen derart ermittelt werden, daß der Schalter (10) durch die Funktionsgruppe Monitor (7) geöffnet wird und dadurch das Syndrom unverändert über den ersten Subtrahierer (8) an den Eingang des zweiten Subtrahierers (9) gelangt, daß mit Hilfe der Funktionsgruppe Syndromvorgabe (15), gesteuert durch den Zähler (14) und das aufbereitete Syndrom (Sa), nacheinander N/2 mögliche Teilsyndrome (Sy) vorgegeben und dem zweiten Subtrahierer (9) sowie der zweiten Tabelle (12) zugeführt werden und sich damit am Ausgang des zweiten Subtrahierers (9) das zu jedem vorgegebenen Teilsyndrom (Sy) zugehörige Teilsyndrom (Sy) ergibt, und die Syndrompaare (Sx und Sy) mittels der dritten und zweiten Tabellen (11,12) in die zugehörigen Positionspaare (Ax und Ay) umcodiert und zum Ausgang geführt werden.

7. Verfahren nach Anspruch 6,
**dadurch gekennzeichnet**, daß in der Funktionsgruppe Syndromvorgabe (15) solche Vorgaben für das Teilsyndrom (Sy) erzeugt werden, daß sich insgesamt N/2 unterschiedliche aufeinanderfolgende Syndrompaare (Sx, Sy) ergeben.

8. Verfahren nach Anspruch 7,
**dadurch gekennzeichnet**, daß die Vorgaben für das Teilsyndrom (Sy) gemäß der Gleichung

$$Sy = f(Z, Sa)$$

Funktionen des Zählerstandes sowie des aufbereiteten Syndroms (Sa) sind.

9. Verfahren zur Fehlermustergenerierung mit einer Einrichtung nach einem der Ansprüche 1 bis 5,

**dadurch gekennzeichnet**, daß im Eins-Fall des niederwertigsten Syndrombits und der daraus folgenden Annahme eines einfachen oder dreifachen zu korrigierenden Fehlers zur Bestimmung der gewünschten Fehlermuster die Lösungen für die Teilsyndrome (Sx, Sy, Sz) des zusammengesetzen Syndroms S = Sx + Sy + Sz ermittelt werden unter Berücksichtigung der Fälle nach den Gleichungen

$$Sx = -Sy$$
$$Sx = -Sz$$
$$Sy = -Sz$$

zur Unterscheidung zwischen einem einfachen und einem dreifachen Fehler.

## Claims

1. Device for error pattern generation when soft-decision decoding blockcodes according to the chase algorithm or a variant of this algorithm, in which a plurality of possible error patterns are generated from the syndrome as an estimated value, obtained from each received data block and independent of the transmitted traffic data, for possible transmission errors and from the positions of symbols having a low degree of reliability selected by means of soft decision, characterised in that the syndrome (S) which is fed to the input of the device and consists of a number of subsyndromes corresponding to the number of possible errors is transmitted on the one hand to a function group monitor (7), which has a signalling output, in order to determine whether the syndrome is zero and whether, in the case of a negative result, the number of errors to be taken into account is even numbered or odd numbered, and is transmitted on the other hand to the one input of a first subtractor (8) whose second input is connected to the one switching contact of a switch (10) which is actuated by the monitor (7) and whose second switching contact is connected to a further input of the device, via which input a possible error position with the position A of the symbol with the smallest reliability is prescribed to the device when a multiple error is assumed, and at the same time the said position A is fed to the output as a possible position for a fault position, the position A being recoded by means of a first table (13) into the corresponding sub-syndrome (Sz) which is subtracted from the syndrome (S) by means of the first subtractor (8) when the switch (10) is closed, in that the output of the first subtractor (8) is connected on the one hand to the one input of a second subtractor (9) and on the other hand to a syndrome preselection function group (15) which successively generates N/2 syndromes and is controlled by a counter (14), the output of said syndrome preselection function group (15) being connected to the second input of the second subtractor (9) as well as to a second table (12), by means of which the sub-syndrome (Sy) is recoded into the associated position (Ay) and conducted to the output, whilst the other output of the second subtractor (9) is conducted to a third table (11), by means of which the sub-syndrome (Sx) is recoded into the associated position (Ax) and conducted to the output, and in that at the output of the first subtractor (8) the processed syndrome (Sa) and the three positions (Ax, Ay and Az) are monitored by the monitor function group (7).

2. Device according to Claim 1, characterised in that at the outputs (Ax, Ay and Az) the desired N/2 position combinations are present which are possible in the case of a corresponding error within a block and the monitor function group (7) reports via its output to the following function units of the decoder that a specific error is to be taken into account and, in the respective case, which output is to be ignored.

3. Device according to Claim 1 or 2, characterised in that the syndrome preselection function group (15) consists of a switching network (16) at which the processed syndrome bits are present and of an arrangement (17) of n+1 changeover switches (Uo-Un) controlled by the switching network (16), via which changeover switches the counter bits (Zo-Zn-1) are switched through to the respective syndrome bits (Syl to Syn) in the event of a corresponding selection of the processed syndrome bits (Sao to San).

4. Device according to Claim 3, characterised in that the processed syndromes (Sa) and the syndromes (Sy) each have a word length of n+l bits and the counter state Z a word length of n bits.

5. Device according to Claim 3 or 4, characterised in that the syndrome preselection function group (15) is implemented with logical gate functions.

6. Process for error pattern generation having a device according to one of Claims 1 to 5, characterised in that, for the zero case of the lowest order syndrome bit and of the resulting assumption of two errors to be corrected, the positions associated with the two subsyndromes (Sx, Sy) of the incoming syndrome are determined in such a way that the switch (10) is opened by the monitor function group (7) and as a result the syndrome is supplied in unchanged form via the first subtractor (8) to the input of the second subtractor (9), in that with the aid of the syndrome preselection function group (15), controlled by the counter (14) and the processed syndrome (Sa), N/2 possible sub-syndromes (Sy) are successively preselected and fed to the second subtractor (9) as well as to the second table (12), and the subsyndrome (Sx) associated with each preselected subsyndrome (Sy) thus results at the output of the second subtractor (9), and the syndrome pairs (Sx and Sy) are recoded into the associated position pairs (Ax and Ay) by means of the third and second tables (11, 12) and fed to the output.

7. Process according to Claim 6, characterised in that in the syndrome preselection function group (15) such preselections for the sub-syndrome (Sy) are generated, and in that a total of N/2 different successive syndrome pairs (Sx, Sy) result.

8. Process according to Claim 7, characterised in that the preselections for the sub-syndrome (Sy) according to the equation

$$Sy = f(Z, Sa)$$

are functions of the counter state as well as of the processed syndrome (Sa).

9. Process for error pattern generation with a device according to one of Claims 1 to 5, characterised in that in the 1 - case of the lowest order syndrome bit and of the resulting assumption of a single or triple error to be corrected, for the purpose of determining the desired error pattern, the solutions for the sub-syndromes (Sx, Sy, Sz) of the composite syndrome $S = Sx + Sy + Sz$ are determined taking into account the cases according to the equations

$$Sx = -Sy$$
$$Sx = -Sz$$
$$Sy = -Sz$$

in order to distinguish between a single and a triple error.


## Revendications

1. Dispositif pour produire des profils d'erreurs lors d'un décodage à décision logicielle de blocs de codes selon l'algorithme Chase ou une variante de cet algorithme, et dans lequel plusieurs profils d'erreurs possibles sont produits à partir du syndrome en tant que grandeur estimée indépendante de chaque bloc reçu des données utiles émises, pour d'éventuels défauts de transmission, et des positions de symboles recherchés au moyen d'une décision logicielle, avec une faible fiabilité,
caractérisé par le fait
que le syndrome (S) envoyé à l'entrée du dispositif et qui est constitué par un nombre de syndromes partiels, qui correspond au nombre d'erreurs possibles, est envoyé, d'une part, à un groupe fonctionnel comportant une sortie de signalisation, à savoir un moniteur (7), pour déterminer si le syndrome est nul ou si, dans le cas d'un résultat négatif, le nombre des erreurs devant être observées est pair ou impair, et, d'autre part, à une entrée d'un premier soustracteur (8), dont la seconde entrée est reliée à un contact de commutation d'un interrupteur (10) commandé par le moniteur (7) et dont le second contact de commutation est relié à une autre entrée du dispositif, par l'intermédiaire de laquelle, dans l'hypothèse d'une erreur multiple, une éventuelle position d'erreur est prédéterminée pour le dispositif, avec la position A du symbole, et ce avec la fiabilité la plus faible, et simultanément est envoyée en tant que position possible pour une position d'erreur à la sortie, la position A étant codée par l'intermédiaire d'un premier tableau (13) en le syndrome partiel correspondant (Sz), qui, lorsque l'interrupteur (10) est fermé, est soustrait du syndrome (S) par l'intermédiaire du premier soustracteur (8), que la sortie du premier soustracteur (8) est reliée, d'une part, à une entrée d'un second soustracteur (9) et, d'autre part, à un groupe fonctionnel, prédétermination de syndromes (15), qui est commandé par un compteur (14) et qui produit successivement N/2 syndromes, et dont la sortie est reliée à la seconde entrée du second soustracteur (9) ainsi qu'à un second tableau (12), au moyen duquel le syndrome partiel (Sy) est codé en la position associée (Ay) et est envoyé à la sortie, tandis que l'autre sortie du second soustracteur (9) est envoyée à un troisième tableau (11), au moyen duquel le syndrome partiel (Sx) est codé en la position associée (Ax) et est envoyé à la sortie, et que le syndrome préparé (Sa), présent à la sortie du premier soustracteur (8) ainsi que les trois positions (Ax, Ay et Az), sont contrôlés par le groupe fonctionnel moniteur (7).

2. Dispositif suivant la revendication 1, caractérisé par le fait qu'aux sorties (Ax,Ay et Az) sont présentes les N/2 combinaisons désirées de positions, qui sont possibles dans le cas d'une erreur correspondante à l'intérieur d'un bloc et que le groupe fonctionnel moniteur (7) signale, par l'intermédiaire de sa sortie, aux unités fonctionnelles aval, qu'une erreur déterminée doit être prise en compte et quelle sortie doit être ignorée et dans quel cas.

3. Dispositif suivant la revendication 1 ou 2, caractérisé par le fait que le groupe fonctionnel prédétermination de syndromes (15) est constitué par un réseau de commutation (16), auquel sont appliqués les bits de syndrome préparés, et par un ensemble (17), commandé par le réseau de commutation (16) et formé de n+1 commutateurs (Uo-Un), par l'intermédiaire desquels, pour une sélection correspondante des bits de syndrome préparés (Sao, San), les bits de comptage (Zo - Zn-1) sont transférés aux bits de syndrome considérés (Syl à Syn).

4. Dispositif suivant la revendication 3, caractérisé par le fait que les syndromes préparés (Sa) et les syndromes (Sy) possèdent chacun une largeur de mot de n+1 bits, et l'état de comptage (Z) possède une largeur de mot de n bits.

5. Dispositif suivant la revendication 3 ou 4, caractérisé par le fait que le groupe fonctionnel prédétermination de syndromes (15) est réalisé au moyen de fonctions de portes logiques.

6. Procédé pour produire des profils d'erreurs avec un dispositif suivant l'une des revendications 1 à 5, caractérisé par le fait que, pour le cas où le bit de syndrome de poids le plus faible est nul et dans l'hypothèse, qui en découle, de deux erreurs devant être corrigées, les positions, qui sont associées aux deux syndromes partiels (Sx, Sy) du syndrome arrivant, sont déterminées de telle façon que l'interrupteur (10) est ouvert par groupe fonctionnel moniteur (7) et que de ce fait le syndrome parvient, à l'état inchangé, par l'intermédiaire du premier soustracteur (8), à l'entrée du second soustracteur (9), et que successivement N/2 syndromes partiels possibles (Sy) sont prédéterminés à l'aide du groupe fonctionnel prédétermination de syndromes (15), d'une manière commandée par le compteur (14) et le syndrome préparé (Sa) et sont envoyés au second soustracteur (9) ainsi qu'au second tableau (12) et qu'on obtient, par conséquent, à la sortie du second soustracteur (9), le syndrome partiel (Sx) associé à chaque syndrome partiel prédéterminé (Sy), et que les couples de syndromes (Sx et Sy) sont codés au moyen des troisième et second tableaux (11,12) en les couples associés de positions (Ax et Ay) et sont envoyés à la sortie.

7. Procédé suivant la revendication 6, caractérisé par le fait que de telles prédéterminations pour le syndrome partiel (Sy) sont produites dans le groupe fonctionnel prédétermination de syndromes (15), et que l'on obtient globalement N/2 couples successifs différents de syndromes (Sx, Sy).

8. Procédé suivant la revendication 7, caractérisé par le fait que les prédéterminations pour le syndrome partiel (Sy) correspondent à la relation

$$Sy = f(Z, Sa)$$

sont des fonctions de l'état de comptage ainsi que du syndrome préparé (Sa).

9. Procédé pour la production de profils d'erreurs avec un dispositif suivant l'une des revendications 1 à 5, caractérisé par le fait que dans le cas où le bit de syndrome de poids le plus faible est un et dans l'hypothèse, qui en découle, d'une erreur simple ou triple devant être corrigée, pour la détermination du profil d'erreurs associé, on détermine les solutions pour les syndromes partiels (Sx, Sy, Sz) du syndrome réuni S = Sx + Sy + Sz en tenant compte des cas correspondant aux relations

$$Sx = -Sy$$
$$Sx = -Sz$$
$$Sy = -Sz$$

pour établir une distinction entre une erreur simple et une erreur triple.

# FIG 1

# FIG 2

# FIG 3

# FIG 4